# EUROPEAN PATENT APPLICATION

(11) **EP 2 037 575 A1**
(43) Date of publication of application: **18.03.2009**
(21) Application number: 07116580.7
(22) Date of filing: 17.09.2007
(51) Int. Cl.: H03H 3/007, H03H 9/24

(54) **Micromechanical resonator**

(71) Applicant: Seiko Epson Corporation, Shinjuku-ku, Tokyo 163-0811 (JP)
(72) Inventor: TANAKA, Kazuaki c/o Epson Europe Electr. GmbH, Sant Cugat del Vallés (Barcelona) 08190 (ES)
(74) Representative: Carpintero Lopez, Francisco

(57) **Abstract**

Method of manufacturing a micromechanical resonator (30,40,60) which comprises the steps of: depositing a first semiconductor layer (3,43,53,63) on a semiconductor substrate (1,41,61), wherein the doping type of said first semiconductor layer (3,43,63) is the opposite of the doping type of said semiconductor substrate (1,41,61); depositing a first dielectric layer (5,45,65) on said first semiconductor layer (3,43,53,63); depositing a first electrode layer (6,46,66) and a second electrode layer (6',46',66') on said first dielectric layer (5,45,65), said electrode layers (6,6',46,46',66,66',66'') corresponding to the electrodes of a micromechanical resonator (30,40,60); depositing a second dielectric layer (7) configured for creating a resonator gap after removing said second dielectric layer (7); depositing a structure layer (8,48,68), said structure layer (8,48,68) corresponding to the structure of said micromechanical resonator (30,40,60); after depositing said first semiconductor layer (3,43,53,63) and before depositing said first dielectric layer (5,45,65), depositing an electrical isolation layer (4,44,54,64,64') on said first semiconductor layer (3,43,53,63), for reducing the parasitic effect caused by an electric path created between the electrodes of the resonator and said substrate (1,41,61).

## Description

### FIELD OF THE INVENTION

The present invention relates to resonators, and more particularly, to micromechanical resonators.

### STATE OF THE ART

Crystal resonators are electronic circuits that use the mechanical resonance of a vibrating crystal of piezoelectric material to create an electrical signal with a very precise frequency. This frequency is commonly used to keep track of time, to provide a stable clock signal for digital integrated circuits, and to stabilize frequencies for radio transmitters. For example, quartz crystal resonators have been used in spread spectrum, radio frequency and wireless applications.

However, crystal resonators have problems of compatibility with semiconductors' fabrication processes.

These problems have been overcome by means of micromechanical resonators. Unlike quartz crystal resonators, micromechanical ones are excellent candidates for integration within a semiconductor substrate, due to its compatibility with the semiconductors' fabrication process.

Y-W. Lin, S. Lee, S-S. Li, Y. Xie, Z. Ren and C. T.-C. Nguyen describe one of these micromechanical resonators in "Series-Resonant VHF Micromechanical Resonator Reference Oscillators," IEEE J. Solid-State Circuits, Vol. 39, No. 12, pp. 2477-2491, Dec. 2004.

Nevertheless, such micromechanical resonators built on semiconductor wafers present some embedded parasitic components, such as resonator to substrate capacitance, series resistance, etc. These parasitic components reduce the electrical performance (Q-factor, insertion loss, etc.) of the resonators.

In particular, the coupling of high frequency signals through the semiconductor substrate underneath a micromechanical resonator causes severe problems. Depending on the operation frequency, and especially upper high frequency (HF) band, this coupling allows signals to pass through the substrate, thereby reducing the signal amplitude through the resonator. The resonator performance is thus reduced by this coupling effect.

### SUMMARY OF THE INVENTION

It is a primary aim of the present invention to overcome the above mentioned problems derived from conventional micromechanical resonators.

This is achieved by means of a method of manufacturing a micromechanical resonator which comprises the steps of: depositing a first semiconductor layer on a semiconductor substrate, wherein the doping type of this first semiconductor layer is the opposite of the doping type of the semiconductor substrate; depositing a first dielectric layer on that first semiconductor layer; depositing a first electrode layer and a second electrode layer on the first dielectric layer, the electrode layers corresponding to the electrodes of a micromechanical resonator; depositing a second dielectric layer configured for creating a resonator gap after removing that second dielectric layer; depositing a structure layer, which corresponds to the structure of a micromechanical resonator. The method further comprises the step of, after depositing that first semiconductor layer and before depositing that first dielectric layer, depositing an electrical isolation layer on a portion of the first semiconductor layer, for reducing the parasitic effect caused by an electric path created between the electrodes of the resonator and the substrate.

The doping type of the electrical isolation layer is the opposite of the doping type of the first semiconductor layer.

Preferably, before depositing that first semiconductor layer on that semiconductor substrate, a step of depositing a highly concentrated doping layer on the semiconductor substrate is done, the doping type of the highly concentrated doping layer being the opposite of the doping type of the semiconductor substrate.

Preferably, the electrical isolation layer which is deposited on a portion of the first semiconductor layer has a cross-sectional length smaller than the cross-sectional distance between a first end of a first electrode and a second end of a second electrode of the resonator, these first and second ends being facing.

In that situation, the first end of the first electrode is the end of the first electrode which is closest to the end of the second electrode which is closest to the first electrode.

Alternatively, that portion of the first semiconductor layer on which that electrical isolation layer is deposited, further extends along an area above which at least a whole one of those electrodes is designed to be deposited.

The invention also refers to a micromechanical resonator which comprises: a semiconductor substrate having a doping type; a first semiconductor layer deposited on that semiconductor substrate, wherein the doping type of that first semiconductor layer is the opposite of the doping type of the semiconductor substrate; an electrical isolation layer deposited on the first semiconductor layer for reducing the parasitic effect caused by an electric path created between the electrodes of the resonator and the substrate; a first dielectric layer deposited on the electrical isolation layer and on the portion of the first semiconductor layer not covered by the electrical isolation layer; a first electrode layer and a second electrode layer deposited on the first dielectric layer, those electrode layers corresponding to the electrodes of the micromechanical resonator; a structure layer corresponding to the structure of the micromechanical resonator; a resonator gap located between the electrode layers and the structure layer.

The doping type of the electrical isolation layer is the opposite of the doping type of the first semiconductor layer.

Preferably, the resonator further comprises a highly concentrated doping layer between the semiconductor substrate and the first semiconductor layer, the doping type of the highly concentrated doping layer being the opposite of the doping type of the semiconductor substrate.

Preferably, the electrical isolation layer which is placed on a portion of the first semiconductor layer has a cross-sectional length smaller than the cross-sectional distance between a first end of a first electrode and a second end of a second electrode of the resonator, these first and second ends being facing.

Alternatively, the portion of the first semiconductor layer on which the electrical isolation layer is placed further extends underneath at least a whole one of the electrodes.

In a particular embodiment, a bridge type resonator having at least three electrodes and two electrical isolation layers is presented.

In a particular embodiment, the resonator further comprises electrical connections for providing input/output ports from/to other equipment to which the micromechanical resonator is configured to be connected.

The advantages of the proposed invention will become apparent in the description that follows.

### BRIEF DESCRIPTION OF THE DRAWINGS

To complete the description and in order to provide for a better understanding of the invention, a set of drawings is provided. Said drawings form an integral part of the description and illustrate a preferred embodiment of the invention, which should not be interpreted as restricting the scope of the invention, but just as an example of how the invention can be embodied. The drawings comprise the following figures:
Figure 1a is a schematic representation of a substrate and electrodes of a conventional micromechanical resonator.
Figures 1b and 1c show two possible equivalent circuits of the conventional micromechanical resonator of figure 1a.
Figure 2a shows a first step of the method of the present invention.
Figure 2b shows an optional step of the method of the present invention.
Figure 2c shows another step of the method of the present invention.
Figure 2d shows another step of the method of the present invention.
Figure 2e shows a further step of the method of the present invention.
Figure 2f shows a further step of the method of the present invention.
Figure 2g shows another step of the method of the present invention.
Figure 2h shows a further step of the method of the present invention.
Figure 2i shows a last step of the method of the present invention.
Figure 3a shows a micromechanical resonator according to an embodiment of the present invention.
Figure 3b shows the equivalent circuit of the micromechanical resonator of figure 3a.
Figure 3c shows the equivalent circuit of a micromechanical resonator.
Figure 4 shows a micromechanical resonator according to an alternative embodiment of the present invention.
Figure 5 shows a detailed aspect of a micromechanical resonator according to the present invention.
Figure 6 shows a bridge type resonator according to the present invention.

### DESCRIPTION OF PREFERRED EMBODIMENTS OF THE INVENTION

In the context of the present invention, the term "highly" used in the expression "highly concentrated" refers to doping concentrations higher than about 10¹⁴ cm⁻³.

In the context of the present invention, the term "sacrificial" referred to a "sacrificial layer of a material" means that such a layer is etched in order to later release a resonator structure for mechanical vibration. Since during the fabrication process it is not possible to deposit or grow any structure on an air space, a "sacrificial" layer is required.

The implementation of the present invention can be carried out as follows:
With reference to the following figures, the fabrication or manufacturing process of the micromechanical resonator 30 of the present invention is described. The following figures represent a cross section of the layers which form the micromechanical resonator. The actual layers obviously form a three-dimensional resonator.

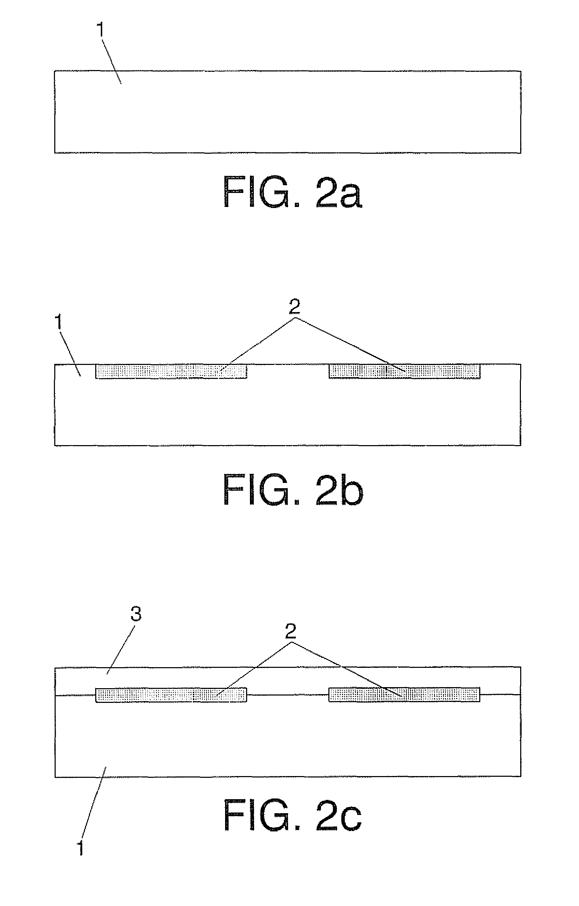

First of all, a semiconductor substrate 1 has to be chosen. Non-limiting examples of conventional semiconductor substrates are silicon substrates, such as p-type or n-type silicon substrates. Other examples of semiconductor substrates are those made of germanium (Ge), gallium arsenide (GaAs) and indium phosphorus (InP). Figure 2a shows a p-type silicon semiconductor substrate, but the invention should not be limited to p-type substrates.

Optionally, highly concentrated doping 2 can be added to the semiconductor substrate 1 in order to reduce resistivity of the next layer to be deposited, as will be explained later. Highly concentrated doping 2 is deposited by any conventional means, such as thermal diffusion, ion implantation, etc. If the semiconductor substrate 1 is of p-type, the doping 2 is of n-type, and vice versa. The doping 2 illustrated in figure 2b is n-type.

Next, a semiconductor layer 3 is deposited on the semiconductor substrate 1 and on the doping area 2, if this optional doping 2 has been deposited. Layer 3 is deposited or grown by any conventional means, such as thermal diffusion, chemical vapour deposition (CVD), epitaxial growth, etc. If the semiconductor substrate 1 is of p-type, layer 3 is of n-type, and vice versa. Layer 3 illustrated in figure 2c is n-type. Non-limiting examples of conventional semiconductor substrates are silicon substrates, germanium (Ge) substrates, gallium arsenide (GaAs) substrates and indium phosphorus (InP) substrates.

As said before, doping area 2 is optional. Adding this doping area 2 is, however, recommended, since thanks to said highly concentrated doping area 2, the resistivity of layer 3 is reduced. This doping area 2 is of the same type as layer 3, but in a higher concentration. In accordance with the definition of "highly concentrated" already given, the doping concentration of this doping area 2 is about at least 10 times higher than that of semiconductor layer 3.

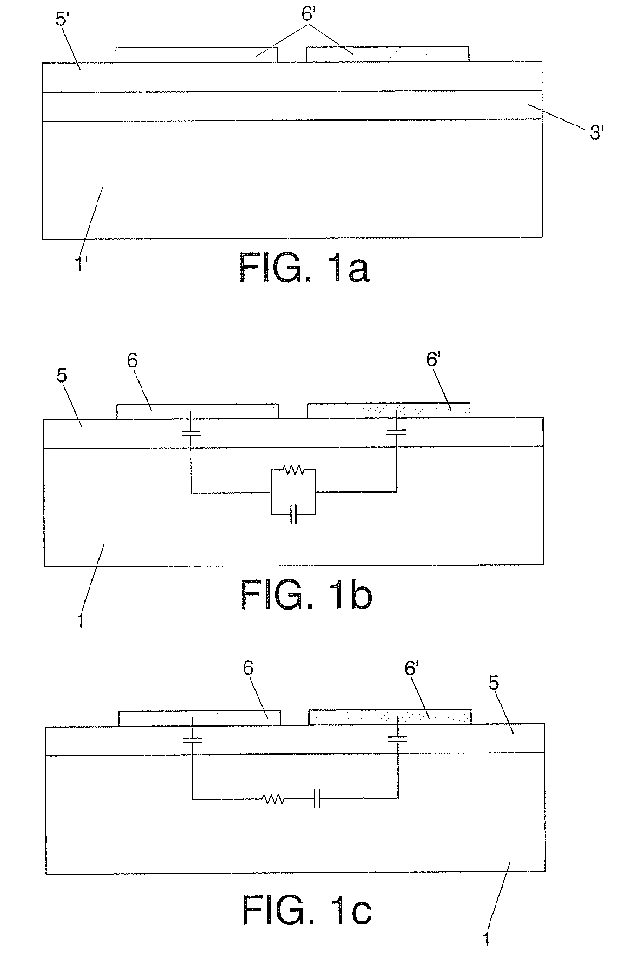

In conventional processes of manufacture, a dielectric layer 5 is then deposited, as shown in figure 1. The purpose of this dielectric layer 5 is to isolate the resonator from the substrate.

After this dielectric, the electrode layers 6 of the resonator are grown.

However, inventors have surprisingly found that, if an electrical separation or isolation layer is added underneath the resonator's electrodes and above the substrate 1, the signal path between the substrate 1 and the electrodes is cut, thus reducing the parasitic effect, thereby improving the electrical performance of the resonator.

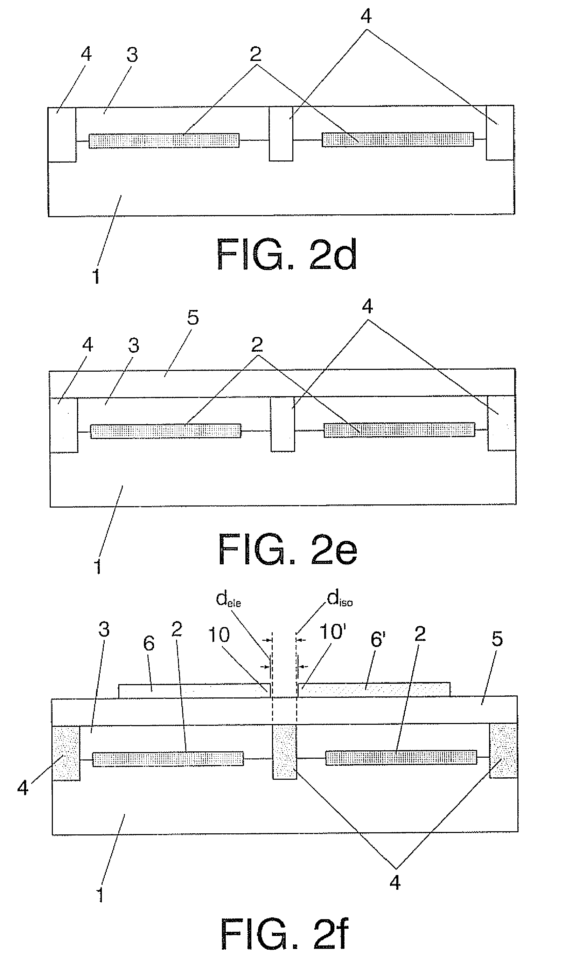

Therefore, a doping area or electrical isolation layer 4 whose type is the opposite one to the one of layer 3 is grown. In other words, if layer 3 is of n-type, doping area 4 is of p-type and vice versa. This doping area or electrical isolation layer 4 is deposited on semiconductor layer 3. This is illustrated in figure 2d, in which case doping area or electrical isolation layer 4 is a p-type one. Non-limiting examples of depositing this doping area or electrical isolation layer 4 are by thermal diffusion and ion implantation among others. In figure 2d, several doping areas 4 are deposited, because several resonators can be built on the same substrate.

Next, a dielectric layer 5 is grown, covering all the surface of the already deposited materials, as shown in figure 2e. As can be seen, dielectric layer 5 covers the electrical isolation layer 4 and the parts of the semiconductor layer 3 not covered by these electrical isolation layer or layers 4. Non-limiting examples of dielectric layers are Silicon Oxide (SiO₂), silicon nitride and silicon oxynitride. In figure 2e, dielectric layer 5 is made of silicon oxide. Dielectric 5 is deposited or grown by any conventional means, such as thermal diffusion, chemical vapour deposition (CVD), epitaxial growth, etc.

Afterwards, first and second electrodes of the micromechanical resonator are created, for which a first electrode layer 6 and a second electrode layer 6' are deposited or grown. This is shown in figure 2f, wherein reference 10 represents the end of the first electrode layer 6 which is closest to the second electrode layer 6' and reference 10' represents the end of the second electrode layer 6' which is closest to the first electrode layer 6. The two separate electrodes formed by layers 6 6' represent different electrical nodes, which form different ports of the resonator (input, output, etc.) Non-limiting examples of materials for creating an electrode layer are poly-Silicon, single crystal silicon and metal, such as aluminium or copper. In figure 2f, deposited electrode layers 6 6' are made of poly-silicon. Pattern etching is then done.

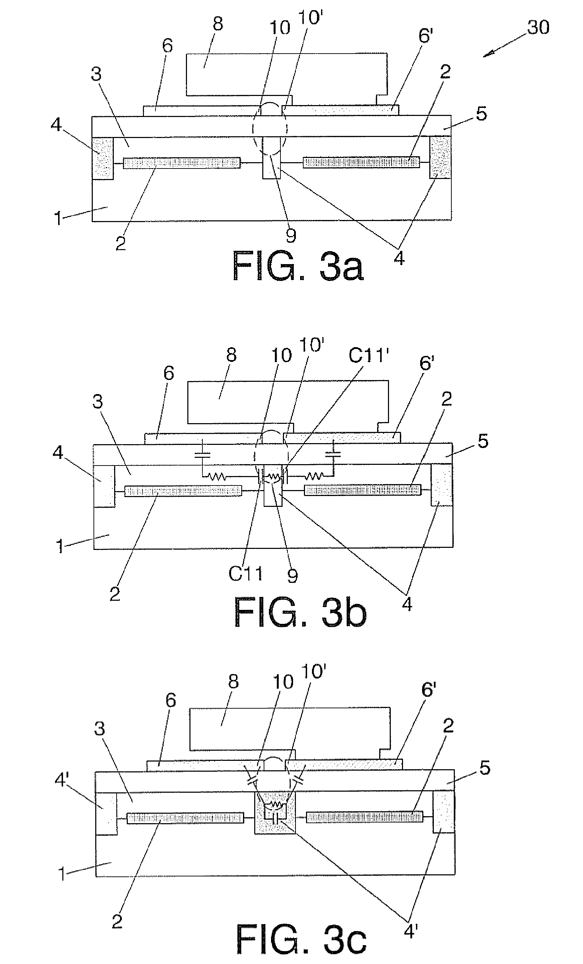

As can be appreciated in the cross section of figure 2f, the cross-sectional distance dₑₗₑ between the ends 10 and 10' of electrode layers 6 and 6' has to be a bit longer than the cross-sectional length dᵢₛₒ of doping area or electrical isolation layer 4. In other words, the doping area or electrical isolation layer 4 is a bit narrower dᵢₛₒ than the separation dₑₗₑ between the ends 10 and 10' of electrode layers 6 and 6'. The reason why dᵢₛₒ has to be shorter than dₑₗₑ is that it prevents the parasitic signal path to travel directly to the electrical isolation layer 4. If dₑₗₑ < dᵢₛₒ, the isolation effect of the electrical isolation layer 4 does not work well. This is explained in detail with reference to figures 3b and 3c. The cross-sectional length dᵢₛₒ only needs to satisfy the above mentioned requirement of dᵢₛₒ < dₑₗₑ. The minimum value of dᵢₛₒ is only limited by practical constraints, such as the equipment of deposition, thermal diffusion, etc. These constraints are out of the scope of the present invention. The minimum value of dₑₗₑ is dependent on or defined by the pattern etching resolution of electrodes 10 and 10'.

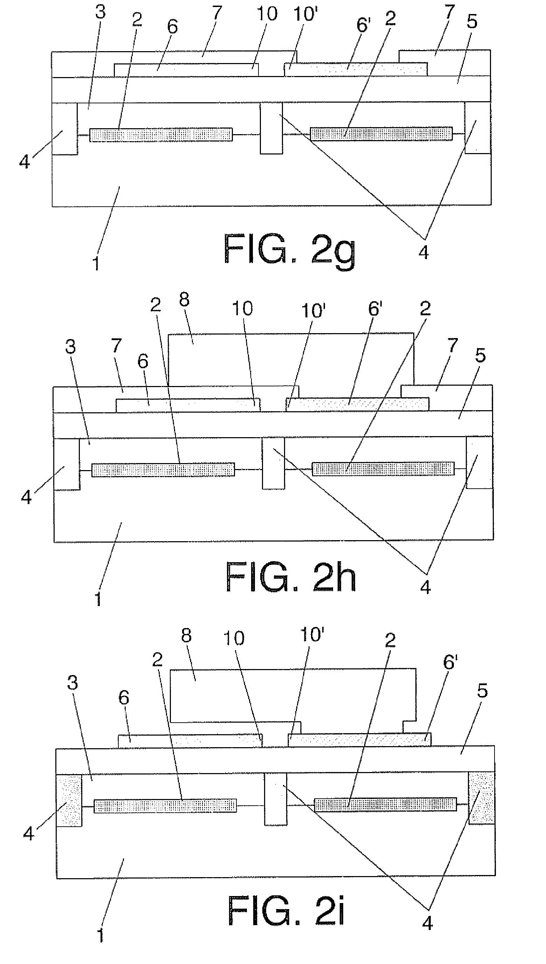

Next, a sacrificial dielectric layer 7 for creating a resonator gap is deposited. Non-limiting examples of dielectric layers are Silicon Oxide (SiO₂), silicon nitride and silicon oxynitride. In figure 2g, dielectric layer 7 is made of silicon oxide. Dielectric layer 7 is deposited or grown by any conventional means, such as thermal diffusion, chemical vapour deposition (CVD), epitaxial growth, etc. This dielectric layer 7 is later removed and a gap remains. This gap or hole forms an electrical contact between the resonator's electrode layers 6 6' and the top layer or layers of the resonator structure, as will be shown later. This sacrificial dielectric layer 7 does not need to cover the whole surface of the electrode layers 6 6'. The amount of electrode layers 6 6', as well as the amount of the remaining dielectric layer 5 which is covered by the sacrificial dielectric layer 7 depends on the specific resonator's design and application.

Afterwards, another layer 8 is deposited on part of the electrode layers 6 6' and on part of said sacrificial dielectric layer 7. This layer is the resonator structure layer 8 and is deposited or grown by any conventional means, such as thermal diffusion, chemical vapour deposition (CVD), epitaxial growth, etc. Non-limiting examples of materials for making such a structure are poly-Silicon, single crystal silicon and metals, such as aluminium or copper. Layer 8 of figure 2h is made of poly-silicon. This structure is resonant, that is, if an AC signal is applied between electrodes 6 and 6', the resonator formed by resonator layer 8 vibrates at the same frequency as the resonator's frequency of vibration of the normal mode (Eigen value), which is the resonance frequency. The amount of electrode layers 6 6', as well as the amount of the sacrificial dielectric layer 7 which is covered by the structure layer 8 depends on the specific resonator's design and application.

Finally, the dielectric layer 7 (i.e. sacrificial oxide) is removed, as illustrated in figure 2i. The fabrication process is finished.

Figure 3a illustrates the micromechanical resonator 30 obtained by the process described with reference to figures 2a-2i. Reference 9 represents the separation area achieved by the invention. This separation area 9 is limited, at its upper side, by the ends 10 10' of the resonator's electrodes 6 6', and at its bottom side, by doping area or electrical isolation layer 4.

The purpose of the doping area or electrical isolation layer 4 is to isolate the ends 10 10' of resonant's electrodes or layers 6 6'. Without the doping area or electrical isolation layer 4 which creates the separation area 9, parasitic current flows between both ends of the electrode layers. Figure 1b shows a possible equivalent circuit of such a micromechanical resonator without doping area. Figure 1c shows an alternative, possible equivalent circuit of such a micromechanical resonator without doping area. The choice of one of the two possible equivalent circuits depends on the electrical characteristic of the materials used.

On the contrary, thanks to the doping area or electrical isolation layer 4, parasitic current is minimized. Figure 3b shows the equivalent circuit of resonator 30 of the invention, in which dᵢₛₒ < dₑₗₑ. Capacitances 11 and 11' create an open circuit, thus avoiding parasitic current to flow. Figure 3c represents the equivalent circuit of a similar resonator, which differs from the one of the present invention in that dᵢₛₒ > dₑₗₑ. As can be noticed, in this the equivalent circuit parasitic signal path is not cut. This equivalent circuit is similar to that of figure 1b.

Focussing on the doping area or electrical isolation layer 4, it must be placed, as explained with reference to figure 2f, at least, underneath the electrode ends 10 10'. According to the embodiment of figure 3b, it has to cover a corresponding part of layer 3 having cross-sectional length = dᵢₛₒ. It is not necessary for it to cover or be inserted within the substrate 1. However, a small insertion therein occurs as a consequence of doping semiconductor layer 3 with doping area 4.

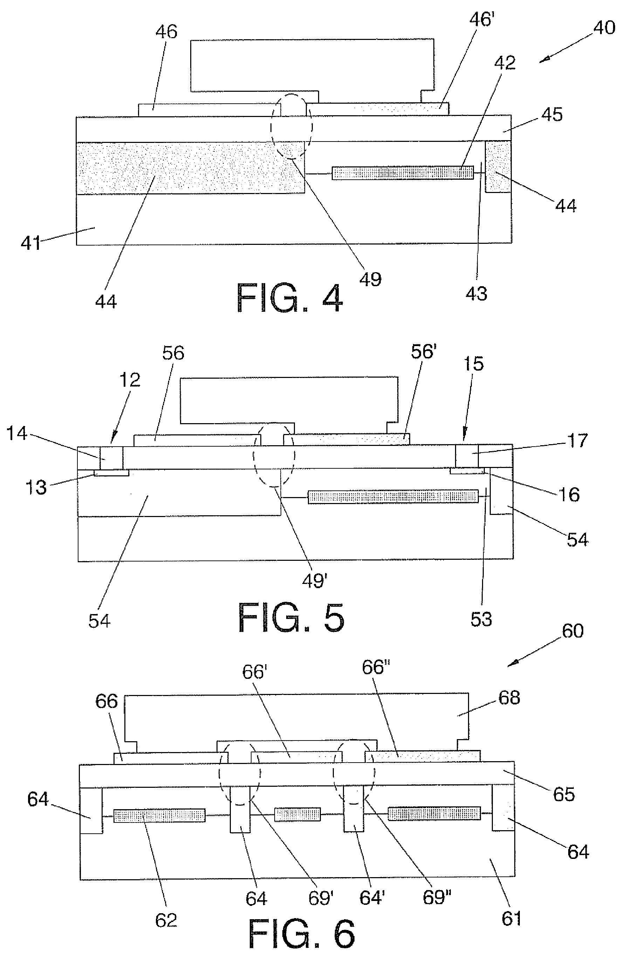

Figure 4 shows an alternative embodiment of a micromechanical resonator 40 of the invention. Like layer 3 of figure 2c, semiconductor layer 43 is an n-type one. Reference 42 represents an optional doping layer similar to the one referred to as 2 in figure 2b. Reference 44 represents a doping area or electrical isolation layer thanks to which a separation area 49 is achieved. Like the one in figure 2b, doping area or electrical isolation layer 44 is a p-type one. As can be seen, this doping area or electrical isolation layer 44 occupies a larger portion than doping layer 4 in figure 3a. In fact, doping area or electrical isolation layer 44 extends all beneath one 46 of the resonant's electrodes 46 46'. Like in figure 2d, several doping areas are deposited, because several resonators can be built on the same substrate. Like doping are 4, doping area or electrical isolation layer 44 creates an electrical separation area 49 between the ends of the electrodes and the doping area 44. At the other end of doping area or electrical isolation layer 44, this doping layer or electrical isolation layer 44 does not start exactly under the end of electrode layer 46', but a bit towards the end of the facing electrode 46, In other words, the projection of the end of the electrode layer 46' which is closest to the facing electrode layer 46 does not overlap with the beginning of the doping area or electrical isolation layer 44.

The micromechanical resonator of the invention also comprises electrical connections, designed for providing input/output ports from/to other equipment. Figure 5 shows such electrical connections 12 15 comprised in the resonator 40 of figure 4. Electrical connection 12 is deposited on a p-type area (doping area 54). Thus, electrical connection 12 requires a high-concentrated p-doping or impurity area 13, deposited or diffused on active p-type doping area 54, in order to make ohmic contact between buried layer 54 and interconnection layer 14. On top of this high-concentrated p-doping area 13 an interconnection area 14 is deposited. In figure 5, interconnection area 14 is made of metal. Non-limiting examples of materials for interconnection layer 14 are metals, such as aluminium, copper, etc. and low resistive silicon layers, such as n/p-doped poly-crystalline silicon and single crystal silicon. Unlike electrical connection 12, electrical connection 15 is deposited on an n-type area (layer 53), Thus, electrical connection 15 requires a high-concentrated n-doping or impurity area 16, deposited on active n-type layer 53, in order to make ohmic contact between buried layer 53 and interconnection layer 17. On top of this high-concentrated n-doping area 16 an interconnection layer 17 is deposited. Examples of interconnection layer 17 are the same ones as indicated for interconnection layer 14.

Figure 6 shows an example of a micromechanical resonator 60 of the invention. In particular, resonator 60 is a bridge type resonator. On a same semiconductor substrate 61, a highly concentrated doping 62 is deposited, and then a semiconductor layer 63 is grown. Then, two doping areas or electrical isolation layers 64 64' whose type is the opposite one to the one of layer 63 are deposited. Next, a dielectric layer 65 is grown, covering all the surface of the already deposited materials. Next, three electrode layers 66 66' 66" are deposited. Left-handed and right-handed electrode layers 66 66" are the same node/terminal, that is to say, the same electrical node or electrical terminal which can be connected to a circuit, a signal source, a load, etc. Centered electrode layer 66' is of different node/terminal from electrode layer 66 66''. Each electrode layer 66 66' 66'' is separated by isolation from the adjacent one or ones by means of doping areas or electrical isolation layers 64 64', because doping area 64 creates an isolation or separation area 69' between the end of electrode layer 66 which is closest to electrode layer 66' and the end of electrode layer 66' which is closest to the said electrode layer 66 and said electrode layer 66. Similarly, doping area 64' creates an isolation or separation area 69'' between the end of electrode layer 66' which is closest to right-handed electrode layer 66'' and the end of the right-handed electrode layer 66'' which is closest to electrode layer 66'. Then, a sacrificial dielectric layer 67 for creating a resonator gap is deposited. Finally, a resonator structure 68 is added and the dielectric layer 67 is removed. Each electrode layer is thus separated by isolation or separation layers that are buried in substrate. A detail structure of bridge type resonator is described, for example, in European patent application EP1777815, by this applicant.

As already mentioned, if substrate is n-type, the polarization of impurities used in the following layer to be deposited is exchanged (to p-type). Similarly, if substrate is p-type, the polarization of impurities used in the following layer to be deposited is exchanged to n-type.

In conclusion, the method of the present invention improves the electrical performance of the micromechanical resonator obtained therefrom, by separating the coupling signal path through the substrate on which the resonator is built.

It should be remarked that the term "layer" when applied to the highly concentrated doping layer 2 42 62, the electrode layer 6 6' 46 46' 66 66' 66'', the electrical isolation layer 4 44 54 64 64', the dielectric layer 7 and the structure layer 8 is not limited to a film covering the whole surface on which it is deposited. On the contrary, it refers to a specific area smaller than or equal to the whole surface on which it is deposited, as apparent from the current description and drawings.

The invention solves the problems derived from parasitic components between a semiconductor substrate and a micromechanical resonator, by applying an isolation process under the region between the ports or ends of the resonator's electrode. The signal path through the substrate 1 between the electrodes 6 6' 46 46' 66 66' 66" is cut by introducing a separation (isolation) layer 4 44 54 64 64' just between the area in the substrate 1 underneath the resonator's electrodes 6 6' 46 46' 66 66' 66''. Consequently, the resonator signal is not reduced or damaged by parasitic effects. The electrical performance of the resonator is thus improved with respect to conventional resonators of the state of the art.

In this text, the term "comprises" and its derivations (such as "comprising", etc.) should not be understood in an excluding sense, that is, these terms should not be interpreted as excluding the possibility that what is described and defined may include further elements, steps, etc.

The invention is obviously not limited to the specific embodiments described herein, but also encompasses any variations that may be considered by any person skilled in the art (for example, as regards the choice of components, configuration, etc.), within the general scope of the invention as defined in the appended claims.

## Claims

1. Method of manufacturing a micromechanical resonator (30, 40, 60) which comprises the steps of:
- depositing a first semiconductor layer (3, 43, 63) on a semiconductor substrate (1, 41, 61), wherein the doping type of said first semiconductor layer (3, 43, 63) is the opposite of the doping type of said semiconductor substrate (1, 41, 61);
- depositing a first dielectric layer (5, 45, 65) on said first semiconductor layer (3, 43, 53, 63);
- depositing a first electrode layer (6, 46, 66, 66'') and a second electrode layer (6', 46', 66') on said first dielectric layer (5, 45, 65), said electrode layers (6, 6', 46, 46', 66, 66', 66") corresponding to the electrodes of a micromechanical resonator (30, 40, 60);
- depositing a second dielectric layer (7) configured for creating a resonator gap after removing said second dielectric layer (7);
- depositing a structure layer (8, 48, 68), said structure layer (8, 48, 68) corresponding to the structure of said micromechanical resonator (30, 40, 60);
**characterised in that** it comprises the step of, after depositing said first semiconductor layer (3, 43, 53, 63) and before depositing said first dielectric layer (5, 45, 65), depositing an electrical isolation layer (4, 44, 54, 64, 64') on a portion of said first semiconductor layer (3, 43, 53, 63), for reducing the parasitic effect caused by an electric path created between said electrodes of said resonator and said substrate (1, 41, 61).

2. Method according to claim 1, wherein the doping type of said electrical isolation layer (4, 44, 54, 64, 64') is the opposite of the doping type of said first semiconductor layer (3, 43, 63).

3. Method according to either claim 1 or 2, further comprising a step of, before depositing said first semiconductor layer (3, 43, 63) on said semiconductor substrate (1, 41, 61), depositing a highly concentrated doping layer (2, 42, 62) on said semiconductor substrate (1, 41, 61), the doping type of said highly concentrated doping layer (2, 42, 62) being the opposite of the doping type of said semiconductor substrate (1, 41, 61).

4. Method according to any preceding claim, wherein said electrical isolation layer (4, 44, 54, 64, 64') which is deposited on a portion of said first semiconductor layer (3, 43, 63) has a cross-sectional length (dᵢₛₒ) smaller than the cross-sectional distance (dₑₗₑ) between a first end (10) of a first electrode (6, 46, 66) and a second end (10') of a second electrode (6', 46', 66') of said resonator, said first end (10) and said second end (10') being facing.

5. Method according to claim 4, wherein said first end (10) of said first electrode (6, 46, 66) is the end of said first electrode which is closest to the end of said second electrode (6', 46', 66') which is closest to said first electrode (6, 46, 66).

6. Method according to claim 4, wherein said portion of said first semiconductor layer (43) on which said electrical isolation layer (44) is deposited, further extends along an area above which at least a whole one of said electrodes (46, 46') is designed to be deposited.

7. Micromechanical resonator (30, 40, 60) which comprises:
- a semiconductor substrate (1, 41, 61) having a doping type;
- a first semiconductor layer (3, 43, 53, 63) deposited on said semiconductor substrate (1, 41, 61), wherein the doping type of said first semiconductor layer (3, 43, 53, 63) is the opposite of the doping type of said semiconductor substrate (1, 41, 61);
- an electrical isolation layer (4, 44, 54, 64, 64') deposited on said first semiconductor layer (3, 43, 53, 63) for reducing the parasitic effect caused by an electric path created between the electrodes of the resonator and said substrate (1, 41, 61);
- a first dielectric layer (5, 45, 65) deposited on said electrical isolation layer (4, 44, 54, 64, 64') and on the portion of said first semiconductor layer (3, 43, 53, 63) not covered by said electrical isolation layer (4, 44, 54, 64, 64');
- a first electrode layer (6, 46, 66, 66'') and a second electrode layer (6', 46', 66') deposited on said first dielectric layer (5, 45, 65), said electrode layers (6, 6', 46, 46', 66, 66', 66'') corresponding to the electrodes of said micromechanical resonator (30, 40, 60);
- a structure layer (8, 48, 68) corresponding to the structure of said micromechanical resonator (30, 40, 60);
- a resonator gap located between said electrode layers (6, 6', 46, 46', 66, 66', 66'') and said structure layer (8, 48, 68).

8. Micromechanical resonator (30, 40, 60) according to claim 7, wherein the doping type of said electrical isolation layer (4, 44, 54, 64, 64') is the opposite of the doping type of said first semiconductor layer (3, 43, 53, 63).

9. Micromechanical resonator (30, 40, 60) according to either claim 7 or 8, further comprising a highly concentrated doping layer (2, 42, 62) between said semiconductor substrate (1, 41, 61) and said first semiconductor layer (3, 43, 53, 63), the doping type of said highly concentrated doping layer (2, 42, 62) being the opposite of the doping type of said semiconductor substrate (1, 41, 61).

10. Micromechanical resonator (30, 40, 60) according to any claim from 7 to 9, wherein said electrical isolation layer (4, 44, 54, 64, 64') which is placed on a portion of said first semiconductor layer (3, 43, 53, 63) has a cross-sectional length (dᵢₛₒ) smaller than the cross-sectional distance (dₑₗₑ) between a first end (10) of a first electrode (6, 46, 66) and a second end (10') of a second electrode (6', 46', 66') of said resonator, said first end (10) and said second end (10') being facing.

11. Micromechanical resonator (40) according to claim 10, wherein said portion of said first semiconductor layer (43) on which said electrical isolation layer (44) is placed further extends underneath at least a whole one of said electrodes (66, 66').

12. Micromechanical resonator (60) according to claim 10 which is a bridge type resonator, having at least three electrodes (66, 66', 66'') and two electrical isolation layers(64, 64').

13. Micromechanical resonator (30, 40, 60) according to any claim from 7 to 12, further comprising electrical connections (12, 15) for providing input/output ports from/to other equipment to which said micromechanical resonator is configured to be connected.
